# EUROPEAN PATENT APPLICATION

(11) **EP 4 033 781 A1**
(43) Date of publication of application: **27.07.2022**
(21) Application number: 20865116.6
(22) Date of filing: 16.09.2020
(51) Int. Cl.: H04R 9/04, H04R 9/02, H05K 1/16, H04R 7/04

(54) **MOVING COIL FOR FLAT PANEL SPEAKER**

(30) Priority: 16.09.2019 KR 20190113399
(71) Applicant: Oclier Co., Ltd., Seoul 04790 (KR)
(72) Inventor: KIM, Dong-Man, Seoul 02638 (KR)
(74) Representative: HGF
(86) International application number: PCT/KR2020/012464
(87) International publication number: WO 2021/054707

(57) **Abstract**

The movable coil for a flat plate speaker according to an embodiment of the present invention includes a PCB coil and a metal coil. The PCB coil plate forms a single layer or multiple layers. In the PCB coil, a coil track is spirally pattern-printed on a single layer PCB coil plate. Otherwise, each of a plurality of coil tracks is spirally pattern-printed on each of multilayer PCB coil plates, and, the plurality of coil tracks are electrically connected to each other. The metal coil is electrically connected to the PCB coil and wound in a planar spiral shape. The coil track includes straight section effective tracks patterned on the upper and lower portions of one surface of the PCB coil plate, respectively, and idle tracks patterned on left and right portions of the one surface of the PCB coil plate, respectively. The straight section effective tracks are formed by connecting multiple lines in parallel, the idle tracks are formed by singular lines, and the coil track is formed in a spiral shape as multiple lines and singular lines are alternately repeated.

## Description

### [Technology field]

The present invention relates to a movable coil for a flat panel speaker. More specifically, the present invention relates to a movable coil for a flat panel speaker capable of maximizing induced electromotive force and controlling impedance.

### [Background technology]

A movable coil plate used in a flat plate speaker is formed by winding or patterning a movable coil in an oval shape on one surface or both surfaces of a plate-shaped coil base.

When a current flows through the movable coil in the movable coil plate, the flowing current generates a magnetic field that expands and then contracts at the same frequency as the audio signal around the movable coil. The movable coil is driven by a magnetic field generated by a magnet in a speaker unit. Therefore, in response to this magnetic field, the movable coil plate moves up and down while interacting with the magnetic field generated in the movable coil. In addition, the movable coil plate is connected to a diaphragm of the speaker unit. Accordingly, as the diaphragm moves up and down, air is pushed out to generate sound by vibration of the air.

Along with the increase in output capacity, such flat panel speakers are being developed to have a thinner and longer structure. Furthermore, in order to increase the output capacity of a flat panel speaker, the development of a flat panel speaker having a structure in which a plurality of magnetic circuits are coupled has also emerged as an important problem.

In order to implement a flat plate speaker, a movable coil plate serving as a bobbin of the movable coil is manufactured into a plate shape. In addition, movable coils are formed on the cross-section or both sides of the plate-shaped movable coil plate.

When a copper wire is wound in a plane and adhered to a bobbin as a movable coil applied to a flat plate speaker, it is difficult to electrically connect the movable coil to an external lead wire. In addition, when the number of turns of the track is raised to increase the inductance (L value) of the movable coil, the impedance and weight of the movable coil increase proportionally. And, when the number of turns of the track is lowered to lower the impedance and weight of the movable coil, the inductance is lowered proportionally. Accordingly, a contradiction is encountered in which the efficiency of the flat panel speaker is lowered.

In addition, as a movable coil applied to a flat plate speaker, a printed circuit board (PCB) coil may be used. In this case, it is impossible to fundamentally solve the above-described problem. And, even if micro-process printed circuit technology is applied to a PCB, it is difficult to maintain uniform quality. For this reason, PCB coils cannot avoid significant cost increases.

Conventionally, there have been studies in which the number of windings of coils of a multilayered PCB pattern coil film is increased to increase the induced electromotive force of the movable coil. Only a multilayer structure of 4 or more layers is possible in the above study. In addition, there is a problem in that it is difficult to improve the disadvantages of unnecessary left and right lateral vibration power generation and weight increase.

Therefore, there is a need for research capable of dramatically solving the problems of the conventional movable coil for flat panel speakers.

### [Prior Art Literature]

(Patent Document 1) Korean Patent Publication No. 1147904 (Publication Date: May 24, 2012)

### [Detailed Description of Invention]

### [Problem to Solve]

An object of the present invention is to provide a movable coil for a flat panel speaker capable of increasing the induced electromotive force of the entire movable coil and minimizing impedance by combining a PCB coil and a metal coil. An object of the present invention is to provide a movable coil for a flat panel speaker capable of remarkably improving the performance of the movable coil.

However, an object of the present invention is not limited to the above objects, and may be variously extended within the spirit and scope of the present invention.

### [Technical Solution]

In order to achieve the object of the present invention, the movable coil for a flat plate speaker according to an embodiment of the present invention includes a PCB coil and a metal coil. The PCB coil plate forms a single layer or multiple layers. In the PCB coil, a coil track is spirally pattern-printed on a single layer PCB coil plate. Otherwise, each of a plurality of coil tracks is spirally pattern-printed on each of multilayer PCB coil plates, and, the plurality of coil tracks are electrically connected to each other. The metal coil is electrically connected to the PCB coil and wound in a planar spiral shape. The coil track includes straight section effective tracks patterned on the upper and lower portions of one surface of the PCB coil plate, respectively, and idle tracks patterned on left and right portions of the one surface of the PCB coil plate, respectively. The straight section effective tracks are formed by connecting multiple lines in parallel, the idle tracks are formed by singular lines, and the coil track is formed in a spiral shape as multiple lines and singular lines are alternately repeated.

According to an embodiment, each of the multilayer PCB coil plates includes a first via hole formed at inner portion thereof and a second via hole formed at one end portion thereof. An inner front end of the coil track is electrically connected to the first via hole, and an outer front end of the coil track is electrically connected to the second via hole. The coil tracks patterned on each of the multilayer PCB coil plates are electrically short-circuited through the first via holes and the second via holes.

According to an embodiment, each of the multilayer PCB coil plates further includes a third via hole formed at other end portion thereof. One end of the metal coil is electrically connected to a first via hole of a predetermined PCB coil plate among the multilayer PCB coil plates, and the other end of the metal coil is electrically connected to a third via hole of the predetermined PCB coil plate.

According to an embodiment, the metal coil includes singular coil line or plural coil lines. Each one end of the coil line is electrically connected to the first via hole of the predetermined PCB coil plate, and each other end of the coil line is electrically connected to the third via hole of the predetermined PCB coil plate.

In accordance with one embodiment, a first lead wire is electrically connected to the second via hole, and a second lead wire is electrically connected to the third via hole.

According to an embodiment, the metal coil is spirally disposed at a position facing the spiral coil track of the PCB coil.

According to an embodiment, the PCB coil plates have a multilayer structure, the metal coil has a single layer structure, the plurality of coil tracks of the PCB coil are connected in parallel with each other, and the metal coil is connected in series with the PCB coil.

### [Effects of Invention]

The movable coil for a flat plate speaker according to an embodiment of the present invention may increase the induced electromotive force of the entire movable coil by combining a PCB coil and a metal coil.

In addition, the movable coil for a flat plate speaker according to an embodiment of the present invention may minimize impedance while remarkably increasing the number of turns of the PCB coil and the metal coil. Accordingly, impedance may be controlled.

In addition, the movable coil for a flat plate speaker according to an embodiment of the present invention may reduce weight and manufacturing cost.

In addition, the movable coil for a flat plate speaker according to an embodiment of the present invention is easy to design a PCB coil plate on which the coil is patterned.

However, the effects of the present invention are not limited to the effects, and may be variously extended within the spirit and scope of the present invention.

### [Brief explanation of drawings]

FIG. 1 is a view illustrating a PCB coil plate of a movable coil for a flat panel speaker according to an embodiment of the present invention.
FIG. 2 is a partially enlarged view of the PCB coil plate of FIG. 1.
FIG. 3 is a diagram illustrating an electrical connection relationship between the multilayer PCB coil plates of FIG. 1.
FIG. 4 is a cross-sectional view illustrating a metal coil of a movable coil for a flat plate speaker according to an embodiment of the present invention.
FIG. 5 is a diagram illustrating an electrical connection relationship between the multilayer PCB coil plates shown in FIG. 3 and the metal coil shown in FIG. 4.

### [Embodiment for implementation of invention]

Hereinafter, embodiments of the present invention will be described in more detail with reference to the accompanying drawings. Among the components of the present invention, a detailed description of what may be clearly understood and easily reproduced by those skilled in the art will be omitted in order not to obscure the subject matter of the present invention.

Hereinafter, a movable coil for a flat plate speaker according to an embodiment of the present invention will be described.

Hereinafter, descriptions of general components such as a damper, a base frame, a magnet, a magnet plate, and a vibration plate constituting the flat plate speaker will be omitted, and will not be illustrated in the drawings.

The movable coil for a flat plate speaker according to an embodiment of the present invention includes a PCB coil 20 and a metal coil 30.

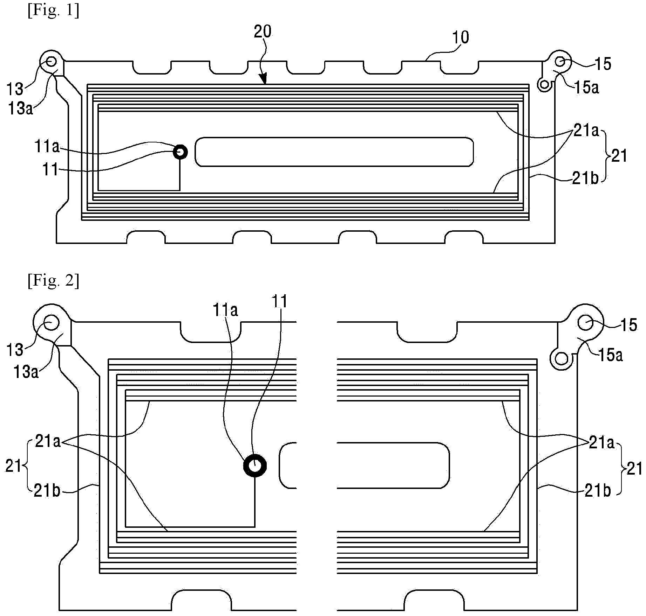

FIG. 1 is a view illustrating a PCB coil plate of a movable coil for a flat panel speaker according to an embodiment of the present invention. FIG. 2 is a partially enlarged view of the PCB coil plate of FIG. 1.

Referring to FIGS. 1 and 2, the PCB coil 20 includes a PCB coil plate 10 and a coil track 21 which is spirally pattern-printed on the PCB coil plate 10.

The PCB coil plate 10 is a printed circuit board (PCB), that is, a plate-shaped coil base. A coil (coil track 21) having high electrical conductivity is patterned on a surface of the coil base.

The PCB coil 20 has a spiral coil track 21 which is patterned and printed on the PCB coil plate 10.

The spiral coil track 21 includes straight section effective tracks 21a and idle tracks 21b.

The straight section effective tracks 21a are patterned on upper and lower portions of one surface of the PCB coil plate 10, respectively. The idle tracks 21b are patterned on left and right portions of the one surface of the PCB coil plate 10, respectively.

The straight section effective tracks 21a are formed by connecting multiple lines in parallel. The idle tracks 21b are formed by singular lines. The coil track 21 is formed in a spiral shape as the multiple lines and the singular lines are alternately repeated.

Specifically, current flows through the multiple lines of the straight section effective tracks 21a (the straight section effective tracks 21a pattern-printed on the upper portion of the one surface of the PCB coil plate 10) of the PCB coil plate 10, in which current flows in a direction of 90 degrees with respect to a direction of a magnet plate (a direction of a magnetic field flowing from N to S electrode) of the magnetic circuit. Current flows through the idle tracks 21b patterned on the left and/or right portions of the one surface of the PCB coil plate 10, which does not correspond to the direction of the magnetic field. Then, current flows through the multiple lines of the reverse current directional straight section effective tracks 21a (the straight section effective tracks 21a pattern-printed on the lower portion of the one surface of the PCB coil plate 10) of the PCB coil plate 10, which is a reverse magnetic field section of the magnetic circuit. While repeating this, the spiral coil track 21 is patterned and printed on the entire PCB coil plate 10.

This maximizes the total length (inductance value, L value) of the entire effective tracks corresponding to the direction of the magnetic field. In addition, it is possible to minimize the impedance value of the entire PCB coil plate 10 by allowing current to flow through multiple lines. Accordingly, the performance of the movable coil for the flat panel speaker may be maximized.

According to an embodiment of the present invention, the widths of each of the multiple lines constituting the straight section effective track 21a may be the same or different. In addition, each line of the multiple lines is disposed to be spaced apart from each other by a predetermined distance, and the predetermined distance may be the same or different.

The PCB coil plate 10 includes a first via hole 11 formed at an inner portion and a second via hole 13 formed at one end portion. In addition, the PCB coil plate 10 further includes a third via hole 15 formed at other end portion.

Copper foil parts 11a, 13a, and 15a may be formed in the first via hole 11, the second via hole 13, and the third via hole 15 of the PCB coil plate 10, respectively. Soldering is possible on each of the copper foil parts 11a and 13a, and 15a.

An inner front end of the coil track 21 is electrically connected to the first via hole 11. An outer front end of the coil track 21 is electrically connected to the second via hole 13.

Other end of the metal coil 30 described below is electrically connected to the third via hole 15 of the predetermined PCB coil plate 10 among the multilayer PCB coil plates 10, 10', and 10". One end of the metal coil 30 is electrically connected to the first via hole 11 of the predetermined PCB coil plate 10 among the multilayer PCB coil plates 10, 10', and 10". The other end of the metal coil 30 is electrically connected to the third via hole 15 of the predetermined PCB coil plate 10. Here, being electrically connected to the first via hole 11 means being electrically connected to the first via hole 11 by being soldered to the copper foil part 11a formed in the first via hole 11, and being electrically connected to the third via hole 15 means being electrically connected to the third via hole 15 by being soldered to the copper foil part 15a formed in the third via hole 15.

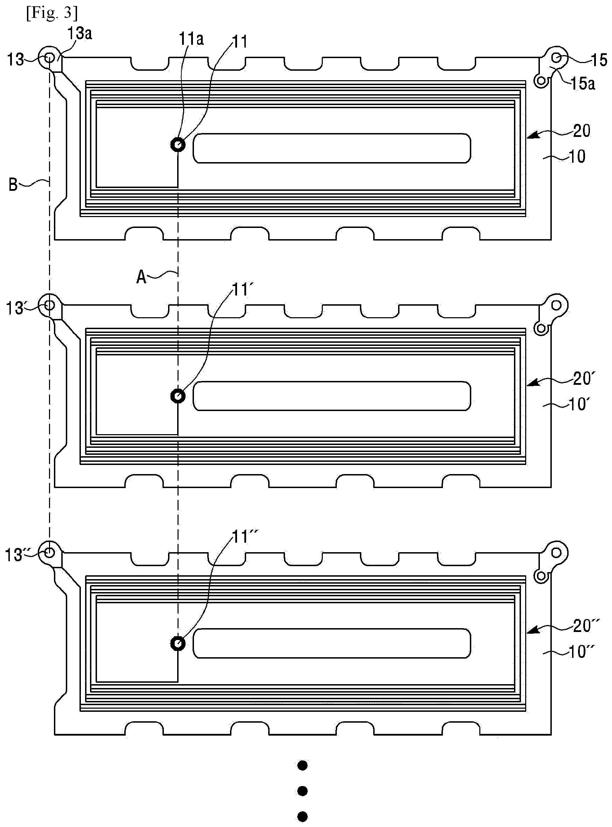

FIG. 3 is a diagram illustrating an electrical connection relationship between the multilayer PCB coil plates of FIG. 1.

Referring to FIGS. 1 to 3, the PCB coil plates 10, 10', and 10" of the movable coil for a flat speaker according to an embodiment of the present invention may be single or plural, and may form single or multi-layer. The spiral coil track 21 may be patterned and printed on a single-layered PCB coil plate 10. In addition, the spiral coil tracks 21 may be patterned on each of the multilayer PCB coil plates 10, 10', and 10", and may be electrically connected (A, B).

The coil tracks 21 patterned on each of the multilayer PCB coil plates 10, 10', and 10" are electrically short-circuited to each other through the first via holes 11, 11', 11" (A) and electrically short-circuited (B) to each other through the second via holes 13, 13', 13" (B). That is, in each of the coil tracks 21 patterned on the multilayer PCB coil plates 10, 10', 10", the first via holes 11, 11', 11" are electrically short-circuited to each other and the second via holes 13, 13', 13" are electrically short-circuited to each other. Accordingly, the PCB coil 20, 20', 20" connected in parallel with each other.

The first via holes 11, 11', 11" formed in each of the plurality of PCB coil plates 10, 10', and 10" are electrically short-circuited to each other and the second via holes 13, 13', 13" formed in each of the plurality of PCB coil plates 10, 10', and 10" are electrically short-circuited to each other (A, B). As described above, the entire multilayer PCB coil plates 10, 10', and 10" are short-circuited through the first via holes 11, 11' and 11" and the second via holes 13, 13' and 13", thereby implementing impedance having a minimum value.

When the PCB coil plates 10, 10', and 10" have a multilayer structure, the induced electromotive force may be significantly increased. In addition, it becomes possible to significantly lower the impedance value.

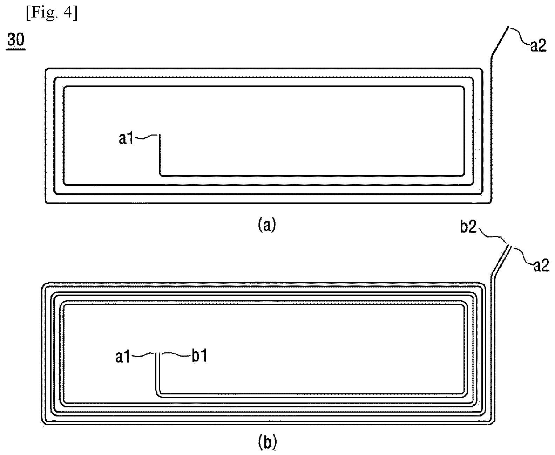

FIG. 4 is a cross-sectional view illustrating a metal coil of a movable coil for a flat plate speaker according to an embodiment of the present invention.

Referring to FIGS. 1 to 4, the metal coil 30 is electrically connected to the PCB coil 20 and is wound in a planar spiral shape. Here, the metal coil 30 may be a copper coil, and may be other metal having high electrical conductivity in addition to copper.

The shape of the metal coil 30 wound in a planar spiral shape may be the same as or similar to the shape of the spiral coil track 21 of the PCB coil 20.

The spiral coil of the metal coil 30 may be disposed at a position (corresponding) facing the spiral coil track 21 of the PCB coil 20. This is to make the metal coil be equally affected by the magnetic field.

One end a1 of the metal coil 30 is electrically connected to the first via hole 11 of the predetermined PCB coil plate 10 among the multilayer PCB coil plates 10, 10', and 10". Other end a2 of the metal coil 30 is electrically connected to the third via hole 15 of the predetermined PCB coil plate 10. Specifically, one end a1 of the metal coil 30 may be electrically connected to the first via hole 11 by being soldered to the copper foil part 11a formed in the first via hole 11, and the other end a2 may be electrically connected to the third via hole 15 by being soldered to the copper foil part 15a formed in the third via hole 15.

The entire multilayer PCB coil plates 10, 10', and 10" are electrically short-circuited (A, B). Copper foil parts 11a and 15a may be formed in the first via hole 11 and the third via hole 15, respectively, of the predetermined PCB coil plate 10 among the electrically short-circuited multilayer PCB coil plates 10, 10', and 10", for electrical connection with the metal coil 30.

One end a1 of the metal coil 30 is soldered to the copper foil part 11a formed in the first via hole 11 of the predetermined PCB coil plate 10. The other end a2 of the metal coil 30 is soldered to the copper foil part 15a formed in the third via hole 15. Accordingly, the first via hole 11 and the third via hole 15 of the predetermined PCB coil plate 10 may be electrically connected to the metal coil 30.

Copper foil parts 11a and 15a may be formed in the first via hole 11 and the third via hole 15 of the PCB coil plate 10 which is electrically connected to the metal coil 30, respectively, among the multilayer PCB coil plates 10, 10', and 10". Soldering is possible on each of the copper foil parts 11a and 15a. The soldering copper foil parts 11a and 15a formed in the via holes 11 and 15 facilitate electrical connection with the external metal coil 30.

The impedance of the entire movable coil is matched by using a metal coil 30 electrically connected (soldered) to the copper foil parts 11a and 15a formed in the via holes 11 and 15. In addition, the induced electromotive force of the PCB coil 20 and the induced electromotive force of the metal coil 30 are added. Accordingly, it is possible to implement a movable coil for a flat panel speaker with remarkable high performance.

The coil lines (stranded lines) of the metal coil 30 are singular or plural. FIG. 4(a) illustrates a case where the coil line of the metal coil 30 are singular, and FIG. 4(b) illustrates a case where there are two coil lines of the metal coil 30.

When there are a plurality of coil lines of the metal coil 30, each one ends a1 and b1 of the coil lines are soldered to and electrically connected to the copper foil part 11a formed in the first via hole 11 of the predetermined PCB coil plate 10. Each of the other ends a2 and b2 are electrically connected to the copper foil part 15a formed in the third via hole 15 of the predetermined PCB coil plate 10.

Even in the case of the metal coil 30, impedance and weight increase proportionally as the number of wound coil lines increases. Thereby, the efficiency of the speaker is lowered. To prevent this, the coil line of the metal coil 30 may be wound in a planar spiral shape with plural, such as two or three strands.

Specifically, by increasing the number of coil lines of the metal coil 30, inductance (L value) may be increased, and induced electromotive force may be increased. Merely increasing (adding) the number of coil lines cannot be a solution in terms of impedance and weight. However, if the cross-sectional area of the coil line is set to 1/2 and wound in two strands, the weight is the same, but an inductance (L value) of twice can be obtained. In this way, the coil line of the metal coil 30 may be wound in a planar spiral shape in two or three strands.

When there are a plurality of coil lines of the metal coil 30, the induced electromotive force may be doubled or more, and impedance control is advantageous.

When there are a plurality of coil lines of the metal coil 30, each coil line is soldered to the copper foil parts 11a and 15a formed in the via holes 11 and 15 of the PCB coil plate 10. Accordingly, the entire metal coil 30 may be electrically connected.

In summary, the metal coil 30 may be wound in a planar spiral shape to a plurality of coil lines (strand lines) with two or three strands, for example, with reduced cross sectional areas of 1/2 or 1/3, to reduce impedance and weight and increase induction electromotive force. In this case, the induced electromotive force (L value) may be doubled or tripled while maintaining the same weight and impedance. Of course, the metal coil 30 may be wound in a planar spiral shape with one strand and then coupled to the PCB coil plate 10 (coupled to the PCB coil 20).

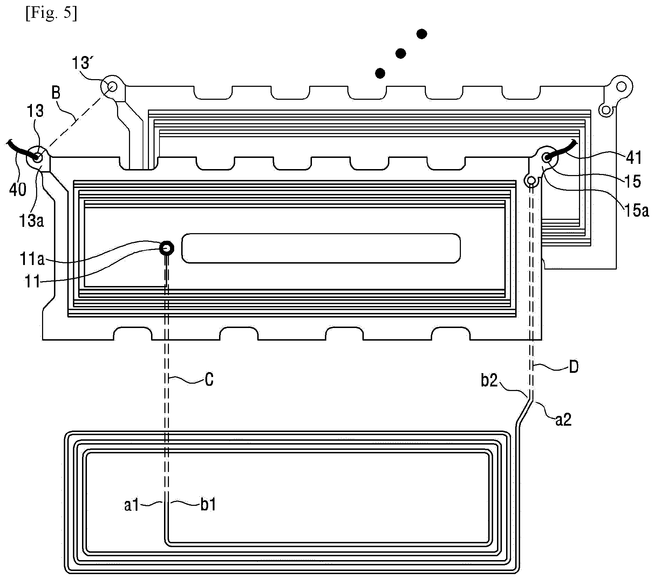

FIG. 5 is a diagram illustrating an electrical connection relationship between the multilayer PCB coil plates shown in FIG. 3 and the metal coil shown in FIG. 4.

Referring to FIGS. 1 to 5, a plurality of PCB coil plates 10, 10', and 10" may form a plurality of layers. Each of the spiral coil tracks 21, 21', 21" may be patterned on each of the multilayer PCB coil plates 10, 10', and 10", and the plurality of coil tracks 21, 21', 21" may be electrically connected (A, B).

The coil tracks 21, 21', 21" patterned on each of the multilayer PCB coil plates 10, 10', and 10" are electrically short-circuited to each other through the first via holes 11, 11' and 11" at the inner front end of the tracks (A). The coil tracks 21, 21', 21" are electrically short-circuited to each other through the second via holes 13, 13', and 13" at the outer end of the track (B). Accordingly, the PCB coils 20, 20', and 20" are connected in parallel with each other.

In addition, one end a1 of the metal coil 30 is electrically connected to the first via hole 11 of the predetermined PCB coil plate 10 among the multilayer PCB coil plates 10 10', and 10" by a copper foil part 11a (C). The other end a2 of the metal coil 30 is electrically connected to the third via hole 15 of the predetermined PCB coil plate 10 by a copper foil part 15a (D). The metal coil 30 is connected in series with the PCB coil 20.

Current flows through multiple lines on the effective track 21a of the PCB coil 20 patterned on the PCB coil plate 10. Accordingly, the impedance may be lowered while increasing the number of turns of the coil. And, the entire multilayer PCB coil plates 10, 10', and 10" are short-circuited in parallel. As a result, the impedance of the entire multilayer PCB coil plates 10, 10', and 10" may be lowered close to zero ohm (0 Ohm). A single or a plurality of metal coils 30 are coupled thereto. Accordingly, the impedance of the entire movable coil may be controlled by using the impedance of the metal coil 30.

More specifically, when an impedance of the movable coil for a flat plate speaker desired by a user is 16 ohms (Ohm), since the impedance of the entire multilayer PCB coil plates 10 is close to 0 ohms, therefore, a metal coil 30 having an impedance of 16 ohms may be connected in series to the PCB coil 20. Thereby, it is possible to manufacture a movable coil for a flat plate speaker having an impedance of 16 ohms.

There are two coil lines of the metal coil 30 shown in FIG. 5. The ends a1 and b1 of the coil lines are soldered to and electrically connected to the copper foil part 11a formed in the first via hole 11 of the predetermined PCB coil plate 10 among the multilayer PCB coil plates 10, 10', and 10" (C). The other ends a2 and b2 are soldered to and electrically connected to the copper foil part 15a formed in the third via hole 15 of the predetermined PCB coil plate 10 (D).

A first lead wire 40 is electrically connected to the second via hole 13 of the predetermined PCB coil plate 10 among the multilayer PCB coil plates 10, 10', and 10". A second lead wire 41 is electrically connected to the third via hole 15 of the predetermined PCB coil plate 10.

When the copper foil parts 13a and 15a are formed in the via holes 13 and 15 of the PCB coil plate 10, electrical connection between the movable coil and the external lead wires 40 and 41 is easy.

The copper foil parts (soldering copper foil parts) 11a, 13a, and 15a may be formed only in the via holes 11, 13, and 15 of the PCB coil plate 10 which is electrically connected to the metal coil 30 and/or external lead wires 40 and 41 among the multilayer PCB coil plates 10, 10', and 10". This is because when the copper foil parts 11a, 13a, and 15a are formed in the entire via holes 11, 13, and 15 of the multilayer PCB coil plates 10, the weight thereof is significant.

The multilayer PCB coil plates 10, 10', and 10" are electrically short-circuited with each other through the first via holes 11, 11', and 11" (A). Accordingly, the first lead wire 40 may be electrically connected to the second via hole 13 of one or more PCB coil plates 10 of the multilayer PCB coil plates 10, 10', and 10".

The second lead wire 41 may be electrically connected to the third via hole 15 of a predetermined PCB coil plate 10 to which the other end of the metal coil 30 is electrically connected.

In the movable coil for a flat panel speaker according to an embodiment of the present invention, the PCB coil plates 10, 10', and 10" may have a multilayer structure, and the metal coil 30 may have a single layer structure.

The PCB coil 20 patterned on the multilayer PCB coil plates 10, 10', and 10" may be connected in parallel to each other. The metal coil 30 may be connected to the PCB coil 20 in series.

The movable coil for a flat plate speaker according to an embodiment of the present invention includes a PCB coil 20 and a metal coil 30. Accordingly, while maximizing the induced electromotive force, an impedance close to 1 ohm or less may be maintained.

The metal coil 30 wound in planar in a single coil line or multiple coil lines (strand lines) is attached to the multilayer PCB coil plates 10, 10', and 10" the whole of which is short-circuited using a via hole. Accordingly, the induced electromotive force generated by the PCB coil 20 formed (pattern printed) on the multilayer PCB coil plates 10, 10', and 10" and the induced electromotive force generated by the metal coil 30 are combined. Through this, the movable coil for a flat panel speaker with breakthrough performance is achieved.

In the PCB coil 20, multiple lines are connected in parallel on the effective tracks 21a and 21b. The PCB coil 20 is configured to be pattern-printed on each of the multilayer PCB coil plates 10, 10', and 10" in which the entire PCB coil 20 is short-circuited. Accordingly, the impedance of the entire PCB coil plates 10 may be reduced to approximately 1 ohm or less while maximizing the induced electromotive force.

In addition, in the case of the metal coil 30, data on impedance and weight according to the length, diameter, cross-sectional area, and singular/multiple of the coil line may be acquired. The acquired (accumulated) data can be easily used. That is, the impedance proportional to the cross-sectional area and length of the metal coil 30 may be predicted. Accordingly, a single or a plurality of strands of metal coils 30 may be coupled to the PCB coil plates 10 of n-layer according to the impedance to be applied. Thereby, it is possible to ultimately maximize the induced electromotive force and control the impedance. Through this, it is possible to manufacture a movable coil for a high-performance flat panel speaker.

In addition, the fine lines (e.g., diameter of 50 microns) of the metal coil 30 have uniform performance compared to the PCB coil plate made by fine processes (e.g., etching of 50 microns). And, the production cost is also low.

In addition, a plurality of coil lines (stranded lines) of the metal coil 30 may be applied such that L value may be increased.

The movable coil for a flat plate speaker according to an embodiment of the present invention combines the advantages of the PCB coil 20 and the metal coil 30 described above. Thereby, it is possible to manufacture a movable coil for a groundbreaking high-performance flat panel speaker.

The movable coil for a flat plate speaker according to an embodiment of the present invention is a combination of a PCB coil 20 and a metal coil 30. Thereby, it is possible to increase the induced electromotive force of the entire movable coil. In addition, impedance may be minimized while significantly increasing the number of turns of the PCB coil 20 and the metal coil 30. And, impedance can be controlled. In addition, the weight and manufacturing cost may be lowered, and the PCB coil plate 10 may be easily designed.

Features, structures, effects, etc. described in embodiments are included in at least one embodiment of the present invention and are not necessarily limited to one embodiment. Furthermore, the features, structures, effects, and the like illustrated in each embodiment may be implemented in combination or modification with respect to other embodiments by a person skilled in the art to which the embodiments belong. Therefore, it should be interpreted that the contents related to these combinations and modifications are included in the scope of the present invention.

In addition, although the embodiment has been mainly described above, this is merely an example and the present invention is not limited, and it will be appreciated by a person skilled in the art that various modifications and applications not illustrated are possible within the scope not departing from the present invention. That is, each component specifically shown in the embodiment may be modified and implemented. And differences related to these modifications and applications should be interpreted as falling within the scope of the present invention as defined in the appended claims.

### [Code's explanation]

10, 10', 10': PCB coil plate
11, 11', 11': first via hole
13, 13', 13': second via hole
15: third via hole
11a, 13a, 15a: copper foil part
20, 20', 20': PCB coil
21 coil track
21a: straight section effective track
21b: idle track
30: metal coil
40: first lead wire
41: second lead wire

## Claims

1. A movable coil for a flat panel speaker, comprising:
a PCB coil including a PCB coil plate and a coil track which is spirally pattern-printed on the PCB coil plate; and
a metal coil electrically connected to the PCB coil and wound in a planar spiral shape, wherein
the coil track includes straight section effective tracks patterned on an upper portion and a lower portion of one surface of the PCB coil plate, respectively, and idle tracks patterned on a left portion and a right portion of the one surface of the PCB coil plate,
the straight section effective tracks are formed by connecting multiple lines in parallel,
the idle tracks are formed by singular lines, and
the coil track is formed in a spiral shape as the multiple lines and the singular lines are alternately repeated.

2. A movable coil for a flat panel speaker, comprising:
a PCB coil including: multilayer PCB coil plates and a plurality of coil tracks each of which is spirally pattern-printed on each of the PCB coil plates and electrically connected to each other,
a metal coil electrically connected to the PCB coil and wound in a planar spiral shape, wherein
the coil track includes a straight section effective tracks patterned on an upper portion and a lower portion of one surface of the PCB coil plate, respectively, and idle tracks patterned on a left portion and a right portion of the one surface of the PCB coil plate, respectively,
the straight section effective tracks are formed by connecting multiple lines in parallel,
the idle tracks are formed by singular lines, and
the coil track is formed in a spiral shape as multiple lines and singular lines are alternately repeated.

3. The movable coil for a flat panel speaker of Claim 2, wherein
each of the multilayer PCB coil plates includes a first via hole formed at inner portion thereof and a second via hole formed at one end portion thereof
an inner front end of the coil track is electrically connected to the first via hole,
an outer front end of the coil track is electrically connected to the second via hole, and
the coil tracks patterned on each of the multilayer PCB coil plates are electrically short-circuited through the first via holes and the second via holes.

4. The movable coil for a flat panel speaker of Claim 3, wherein
each of the multilayer PCB coil plates further includes a third via hole formed at other end portion thereof,
one end of the metal coil is electrically connected to a first via hole of a predetermined PCB coil plate among the multilayer PCB coil plates,
other end of the metal coil is electrically connected to a third via hole of the predetermined PCB coil plate.

5. The movable coil for a flat panel speaker of Claim 3, wherein
each of the multilayer PCB coil plates further includes a third via hole formed at other end portion thereof,
the metal coil includes singular coil line or plural coil lines,
each one end of the coil line is electrically connected to the first via hole of the predetermined PCB coil plate among the multilayer PCB coil plates,
each other end of the coil line is electrically connected to the third via hole of the predetermined PCB coil plate.

6. The movable coil for a flat panel speaker of Claims 4 or 5, wherein
a first lead wire is electrically connected to the second via hole,
a second lead wire is electrically connected to the third via hole.

7. The movable coil for a flat panel speaker of any of Claims 2 to 5, wherein
the metal coil is spirally disposed at a position facing the spiral coil track of the PCB coil.

8. The movable coil for a flat panel speaker of Claim 2, wherein
the PCB coil plates have a multilayer structure,
the metal coil has a single layer structure,
the plurality of coil tracks of the PCB coil are connected in parallel with each other, and
the metal coil is connected in series with the PCB coil.
